Europäisches Patentamt

**European Patent Office**

**Office européen des brevets**

(11) Veröffentlichungsnummer: **0 286 867**

**A1**

(12) **EUROPÄISCHE PATENTANMELDUNG**

(21) Anmeldenummer: **88104371.5**

(22) Anmeldetag: **18.03.88**

(51) Int. Cl.⁴: **G01L 9/06**

(30) Priorität: **18.03.87 DE 3708831**

(43) Veröffentlichungstag der Anmeldung:
    **19.10.88 Patentblatt 88/42**

(84) Benannte Vertragsstaaten:
    **DE FR GB**

(71) Anmelder: **Siemens Aktiengesellschaft Berlin und München**
    **Wittelsbacherplatz 2**
    **D-8000 München 2(DE)**

(72) Erfinder: **Stein, Karl-Ulrich, Dr.-Ing.**
    **Isartalstrasse 14**
    **D-8025 Unterhaching(DE)**

(54) **Halbleiter-Drucksensor mit einem Gehäuse und Verfahren zu dessen Herstellung.**

(57) Die Erfindung betrifft einen Drucksensor mit einem Drucksensorchip (1) aus Halbleitermaterial, der einen piezoresistiven Membranteil (4) aufweist und in einem Gehäuse (3) angeordnet ist, das eine Öffnung (6) zur Übertragung des Umgebungsdruckes auf das Membranteil (4) des Drucksensorchips (1) aufweist. Dieser Drucksensor soll mit einem rationell und kostengünstig herstell-und bestückbaren Gehäuse versehen sein, das zudem einen Schutz für den Drucksensor während des Testens, Bestükkens und im Einsatz in der Schaltung bietet. Die Erfindung sieht hierzu vor, daß der Drucksensorchip (1) auf einem Leiterband (2) befestigt ist, daß das Leiterband (2) Bestandteil des Gehäuses (3) ist, daß das Gehäuse (3) aus einem festen Kunststoff besteht, und daß der Drucksensorchip (1) im Inneren des Gehäuses (3) zumindest im Bereich des Membranteils (4) mit einer Abdeckung (5) aus einem weichplastischen, zur Druckübertragung geeigneten Stoff versehen ist.

Der erfindungsgemäße Drucksensor findet als Absolut-Drucksensor Anwendung.

EP 0 286 867 A1

## Halbleiter-Drucksensor mit einem Gehäuse und Verfahren zu dessen Herstellung

Die Erfindung betrifft einen Drucksensor gemäß dem Oberbegriff des Anspruchs 1.

Auf dem Gebiet der Druckmesser kommen Halbleiter-Drucksensoren immer mehr zur Anwendung. Bei diesen bekannten Drucksensoren, beispielsweise Relativdrucksensoren, bildet eine Siliciummembran das Kernstück des Bauelementes, in der durch Ionenimplantation Widerstandsbahnen erzeugt sind. Wird auf die Membran ein Druck ausgeübt, so biegt sich diese durch. Das führt zu Widerstandsänderungen nach dem piezoresistiven Effekt. Dieser Effekt wird ausgenutzt, um die physikalische Größe Druck in ein analoges elektrisches Signal umzuwandeln (Siemens Components 23 (1985) Heft 2, S. 64 bis 67). Die Drucksensorchips sind dabei in Gehäuse eingebaut, die vorzugsweise aus Metall bestehen und im Deckel eine Öffnung zur Übertragung des Umgebungsdruckes auf die druckempfindliche Chipoberfläche besitzen. Derartige Gehäuse sind relativ kostspielig und unhandlich. Man ist deshalb bestrebt, Kunststoff-Steckgehäuse und Kunststoff-Miniaturgehäuse für Oberflächenmontage bei Drucksensoren zu verwenden.

Der Erfindung liegt die Aufgabe zugrunde, einen Drucksensor mit einem rationell und kostengünstig herstell-und bestückbaren Gehäuse auszurüsten, das zudem einen Schutz für den Drucksensor während des Testens, Bestückens und im Einsatz in der Schaltung bietet.

Diese Aufgabe wird erfindungsgemäß mit einem Drucksensor mit den Merkmalen des Anspruchs 1 gelöst.

Vorteilhafte Ausgestaltungen und Weiterbildungen der Erfindung sind Gegenstands zusätzlicher Ansprüche.

Eine derartige Drucksensor-Verpackung ist insbesondere für Absolut-Drucksensoren anwendbar, da hier nur der Umgebungsdruck des Gehäuses gegenüber dem Vakuum im Inneren des Drucksensor-Chips gemessen wird.

Mit der Erfindung wird erreicht, daß ein Drucksensor-Chip vorteilhaft in ein Standard-Kunststoff-Steckgheäuse oder Standard-Kunststoff-Miniaturgehäuse verpackt werden kann und daß der Umgebungsdruck auf die druckempfindliche Chip-Oberfläche durch die weiche Plastikabdeckung einwirken kann, die durch die Öffnung im harten Kunststoffgehäuse dem Umgebungsdruck ausgesetzt ist.

Die Gehäuseausführung enthält vorteilhaft ein Standard-Leiterband als Systemträger für eines der bevorzugt verwendbaren Standardgehäuse. Der Drucksensor-Chip wird auf das Leiterband im üblichen Verfahren durch Löten aufgebracht. Nach der Kontaktierung des Chips wird er durch eine weiche Plastikabdeckung, vorzugsweise durch ein Silicon-Gel, ähnlich wie bei einem in der Halbleitertechnik bekannten sogenannten Tröpfelverfahren abgedeckt. Beim anschließenden Umpressen mit Duroplast - oder nach dem Umpressen - wird dafür gesorgt, daß der Umgebungsdruck auf die weiche Plastikabdeckung wirken kann. Dies kann dadurch erfolgen, daß die weiche Plastikabdeckung bereits beim Duroplast-Umpressen bis zur Oberseite des Werkzeugs reicht, oder dadurch, daß eine Öffnung beim Umpressen - z.B. durch einen kleine Stift im Werkzeug oder nachher durch Herausätzen mit Maske oder Strahl - hergestellt wird.

Dieses Prinzip ist durch geeignete Wahl der Materialien für harte Umhüllung und weiche Abdeckung weitgehend abwandelbar. So kann z.B. auch bei passender Wahl der Materialien für die weiche Plastikabdeckung diese Abdeckung in einem Ätz-oder Lösverfahren zumindest zum Teil entfernt werden.

Der besondere Vorteil der Anordnung besteht darin, daß nur mit dem zusätzlichen Schritt des Aufbringens einer weichen Plastikabdeckung geeigneter Beschaffenheit und geeigneter Abmessungen, sonst aber Standardtechnik, ein Absolut-Drucksensor gefertigt werden kann.

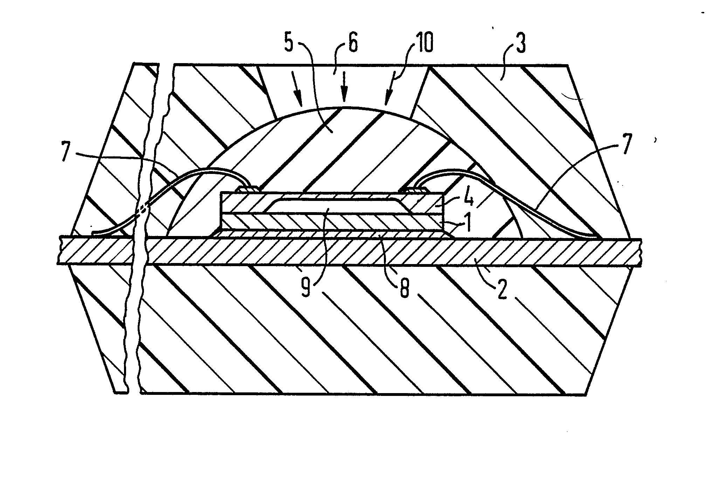

Anhand eines in der Figur der Zeichnung rein - schematisch dargestellten, bevorzugten Ausführungsbeispiels wird die Erfindung näher erläutert.

In der Figur ist als Drucksensor ein Absolut-Drucksensor im Schnitt dargestellt. Der Drucksensorchip 1 besteht aus Halbleitermaterial, vorzugsweise aus Silicium, und weist einen piezoresistiven Membranteil 4 auf. Die Widerstandsbrücken im Membranteil 4, die zu den piezoresistiven Eigenschaften des Halbleiterbauteils führen, werden vorzugsweise durch Ionenimplantation erzeugt. Der Drucksensorchip 1 ist direkt auf dem Leiterband 2 befestigt, das Bestandteil des Gehäuses 3 ist. Die Befestigung des Drucksensorchips 1, die vorzugsweise durch Löten vorgenommen werden kann, erfolgt in diesem Ausführungsbeispiel durch die Befestigungsschicht 8. Das Gehäuse 3 besteht aus Duroplast und weist eine Öffnung 6 zur Übertragung des Umgebungsdruckes auf das Membranteil 4 des Drucksensorchips 1 auf. Die Richtung des durch die Öffnung 6 auf das Membranteil 4 einwirkenden Umgebungsdruckes ist durch Pfeile 10 angedeutet. Das Membranteil 4 des Drucksensorchips 1 ist mittels Drähten 7, beispielsweise Aluminium-Bonddrähten, mit dem Leiterband 2 kontaktiert. In diesem Ausführungsbeispiel ist der gesamte Innenraum des Gehäuses 3 mit der Abdeckung 5 aus weichplastischem Stoff, vorzugsweise aus Silicon-Gel, ausgefüllt und somit der Drucksensorchip 1 mit Membranteil 4 vollkommen abgedeckt. Der dargestellte Drucksensor wird als Absolut-Drucksensor angewendet. Zu diesem Zweck ist der Hohlraum 9 zwischen dem Drucksensorchip 1 und dessen Membranteil 4 evakuiert.

## Ansprüche

1. Drucksensor mit einem Drucksensorchip aus Halbleitermaterial, der einen piezoresistiven Membranteil aufweist und in einem Gehäuse angeordnet ist, das eine Öffnung zur Übertragung des Umgebungsdruckes auf das Membranteil des Drucksensorchips aufweist,
**dadurch gekennzeichnet**, daß der Drucksensorchip (1) auf einem Leiterband (2) befestigt ist, daß das Leiterband (2) Bestandteil des Gehäuses (3) ist, daß das Gehäuse (3) aus einem festen Kunststoff besteht, und daß der Drucksensorchip (1) im Inneren des Gehäuses (3) zumindest im Bereich des Membranteils (4) mit einer Abdeckung (5) aus einem weichplastischen, zur Druckübertragung geeigneten Stoff versehen ist.

2. Drucksensor nach Anspruch 1, **dadurch gekennzeichnet**, daß der Drucksensorchip (1) aus Silicium besteht, dessen Membranteil (4) durch Ionenimplantation verliehene piezoresistive Eigenschaften besitzt.

3. Drucksensor nach Anspruch 1 oder 2, **dadurch gekennzeichnet**, daß der weichplastische Stoff ein Silicon-Gel ist.

4. Drucksensor nach einem der Ansprüche 1 bis 3, **dadurch gekennzeichnet**, daß der feste Kunststoff ein Duroplast ist.

5. Drucksensor nach einem der Ansprüche 1 bis 4, **dadurch gekennzeichnet**, daß der Drucksensorchip (1) im Inneren im Bereich des Membranteils (4) einen evakuierten Hohlraum aufweist und als Absolut-Drucksensor verwendet wird.

6. Verfahren zum Herstellen eines Drucksensors nach einem der Ansprüche 1 bis 5, **dadurch gekennzeichnet**, daß der Drucksensorchip (1) auf das Leiterband (2) durch Löten aufgebracht wird, daß der Drucksensorchip (1) nach dem Kontaktieren mit dem Leiterband (2) mit einer Abdeckung (5) aus Weichplastik vorzugsweise aus Silicon-Gel versehen wird, und daß zum Bilden des Gehäuses (3) die Anordnung anschließend mit Duroplast umpreßt wird, wobei während des Umpressens bzw. nach dem Umpressen die Öffnung (6) zur Übertragung des Umgebungsdruckes auf die Abdeckung (5) bzw. auf den Membranteil (4) freigelassen bzw. freigelegt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 200 448 (PHILIPS PATENTVERWALTUNG GmbH) * Zusammenfassung; Ansprüche 2,11,12; Seite 9, Zeile 19; Figuren * --- | 1,3-6 | G 01 L 9/06 |
| Y | TOUTE L'ELECTRICITE, Nr. 474, Mai 1982, Seiten 23-25, Paris, FR; J.-P. DELAPORTE: "Une nouvelle technologie pour les capteurs de pression" * Figur 5, Seite 24, linke Spalte, Abschnitt 2 * --- | 1-3,5,6 | |
| Y | WESCON PROCEEDINGS, San Francisco, 19.-22. November 1985, Band 29, Seiten 1-5, New York, US; R.K. FRANK et al.: "An update on the integration of silicon pressure sensors" * Figur 6; Seite 1, linke Spalte, "Background" * --- | 1-3,6 | |
| Y | PATENT ABSTRACTS OF JAPAN, Band 8, Nr. 214 (P-304)[1651], 29. September 1984; & JP-A-59 97 029 (HITACHI SEISAKUSHO K.K.) 04-06-1984 * Insgesamt * ----- | 1,3,5,6 | RECHERCHIERTE SACHGEBIETE (Int. Cl.4)  G 01 L 9 |

Der vorliegende Recherchenbericht wurde für alle Patentansprüche erstellt

| Recherchenort | Abschlußdatum der Recherche | Prüfer |
|---|---|---|
| DEN HAAG | 11-08-1988 | VAN ASSCHE P.O. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument